# EUROPEAN PATENT APPLICATION

(11) **EP 1 403 931 A2**
(43) Date of publication of application: **31.03.2004**
(21) Application number: 03021944.8
(22) Date of filing: 29.09.2003
(51) Int. Cl.: H01L 31/18, H01L 31/068, H01L 31/0352, H01L 31/0236

(54) **Method for growing a silicon film, method for manufacturing a solar cell, semiconductor substrate, and solar cell**

(30) Priority: 30.09.2002 JP 2002287338
(71) Applicant: CANON KABUSHIKI KAISHA, Ohta-ku, Tokyo (JP)
(72) Inventor: Mizutani, Masaki, Ohta-ku, Tokyo (JP); Ishihara, Shunichi, Ohta-ku, Tokyo (JP); Nakagawa, Katsumi, Ohta-ku, Tokyo (JP); Yoshino, Takehito, Ohta-ku, Tokyo (JP); Nishida, Shoji, Ohta-ku, Tokyo (JP)
(74) Representative: Leson, Thomas Johannes Alois, Dipl.-Ing.

(57) **Abstract**

According to the present invention, at the time of growing a silicon film by liquid epitaxy on a substrate, a bulk portion having substantially no void is formed and then a surface portion having plural protrusions that overhang in a lateral direction is formed. As a result, it is possible to form a silicon film having an uneven structure suitable for increasing optical path length on a surface layer of a semiconductor substrate without performing an additional process for forming an uneven structure. Therefore, it is possible to obtain a semiconductor substrate particularly suitable for a solar cell having an improved short circuit current property at low cost. Accordingly, it is possible to provide a solar cell having high efficiency and being low in price.

## Description

### BACKGROUND OF THE INVENTION

### Field of the Invention

The present invention relates to a solar cell having an uneven light confining structure, a semiconductor substrate which is preferably used as a component for the solar cell, and a manufacturing method therefor. More particularly, the present invention relates to a solar cell utilizing a silicon film formed on a substrate by a liquid phase epitaxy, a semiconductor substrate which is preferably used as a component for the solar cell, and a manufacturing method therefor.

### Related Background Art

Conventionally, a technique in which an uneven light confining structure is formed on the surface of a solar cell to increase optical path length of incident light has been widely used. Japanese Patent Application Laid-Open No. 03-023678 (whose patent application was filed by Mitsubishi Electric Corporation) describes a structure in which a number of cylindrical light receiving surfaces are formed on a flat light receiving surface so that incident light is introduced into a dead end in the cylinder.

Furthermore, Japanese Patent Application Laid-Open No. 62-101084 (whose patent application was filed by Sharp Corporation) discloses a light confining solar cell having a concave space which has capability of confining at least a part of incident light in the surface portion of the solar cell.

It is conceivable that a light confining structure in which incident light is introduced into a dead end is significantly effective to increase short circuit current. However, the above-mentioned publications do not disclose or suggest a method of forming such structure individually or in combination.

As an example of a method of forming an uneven structure in the surface layer of a solar cell, a method which mechanically grinds the surface of the solar cell by using a rotary grind-stone is known. However, according to this method using a rotary grind-stone, additional processes are required for forming an uneven structure which cause cost increase. Furthermore, according to this method, it is difficult to form the above-mentioned dead end structure.

### SUMMARY OF THE INVENTION

The present invention has been made in view of solving the above-mentioned problems. Therefore, it is an object of the present invention to provide a solar cell having a light confining structure capable of effectively confining light such as a dead end structure and being less expensive, and a semiconductor substrate which is preferably used as a component for the solar cell.

It is also an object of the present invention to provide a method for manufacturing a solar cell having a structure capable of effectively confining light such as a dead end structure, which does not require additional processes for forming an uneven structure.

The present invention has been accomplished in order to effectively attain the above-mentioned objects and the present invention is to provide a method for growing a silicon film by liquid phase epitaxy on a surface of a substrate in contact with a solution containing at least silicon by decreasing a temperature of the solution, comprising the steps of: forming a bulk portion having substantially no void; and forming a surface portion having plural protrusions that overhang in a lateral direction. Further, a method for manufacturing a solar cell according to the present invention includes forming a P-N junction on the silicon film. Further, a semiconductor substrate according to the present invention comprises an inclined plane and plural grooves of a gap portion communicated with the inclined plane on a surface layer composed of silicon. Further, a semiconductor substrate according to the present invention comprises a surface portion having an inclined plane affected by a crystal structure of silicon and plural protrusions that overhang in a lateral direction in a surface layer composed of silicon, in which plural grooves having openings narrowed due to the protrusions overhanging in the lateral direction are formed on the surface portion. Furthermore, a solar cell according to the present invention comprises a semiconductor substrate described above as a component, in which a P-N junction is formed on a surface layer composed of silicon. Further, a solar cell comprises a semiconductor substrate having an inclined plane and plural grooves of a gap portion communicated with the inclined plane on a surface layer composed of silicon, and a collector electrode crossing over the plural grooves on the semiconductor substrate.

### BRIEF DESCRIPTION OF THE DRAWINGS

Fig. 1 is a schematic cross-sectional view illustrating an embodiment of a silicon film according to the present invention by use of a cross-sectional picture of the silicon film.
Fig. 2 is a schematic side cross-sectional view illustrating an example of a liquid phase epitaxial growth apparatus for forming a silicon film according to the present invention.
Fig. 3 is a schematic cross-sectional view illustrating an embodiment of a solar cell according to the present invention.

### DESCRIPTION OF THE PREFERRED EMBODIMENTS

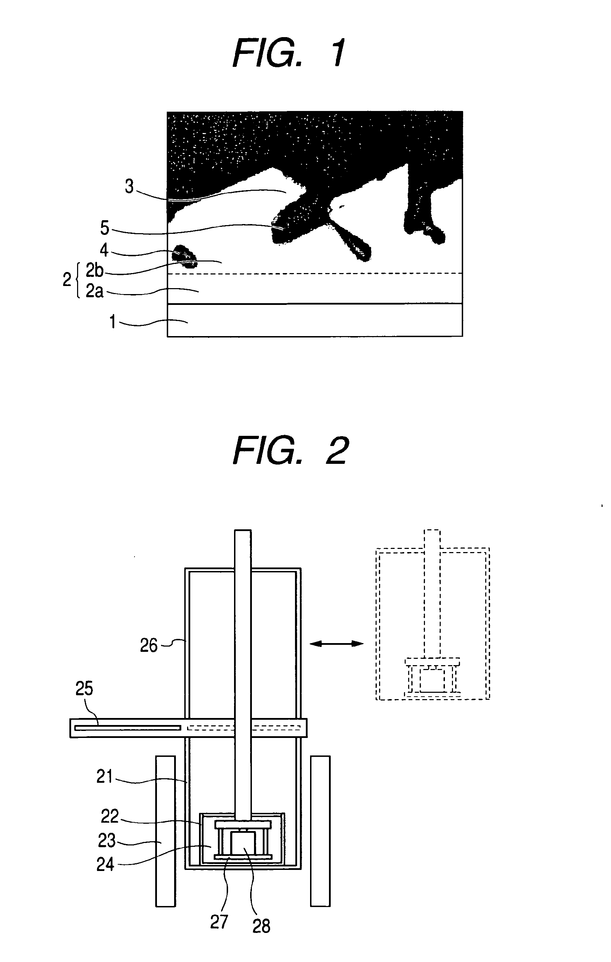

Fig. 1 is a schematic cross-sectional view illustrating an embodiment of a silicon film according to the present invention by use of a cross-sectional picture of the silicon film.

Fig. 1 indicates that a silicon film 2, which is a characteristic component of the present invention, is formed on a substrate 1. As shown in Fig. 1, the silicon film 2 in the present invention includes a bulk portion 2a and a surface portion 2b. The bulk portion 2a includes substantially no void in a cross-sectional view. The surface portion 2b includes plural protrusions that overhang (overhangs 3) in a lateral direction.

In the present specification, the phrase "substantially no voids" means the case that there exist no voids at all or the case that the number of a minute void which appears in the cross section is one void/cm² or less. Here, the phrase "minute void which appears in the cross section" means, for example, a void having a spherical diameter of 0.1 µm or more when the void is regarded as an equivalent of a sphere.

Such a structure is obtained by growing protrusions that overhang in a lateral direction at the final stage of a liquid phase growth method which epitaxially grows the silicon film 2 on the substrate 1. Although the mechanism by which such a structure is obtained is not clear, experiments performed by the present inventors suggest a phenomenon that a flat growth initially occurs, and overhanging of the protrusions in a lateral direction is initiated upon formation of a minute unevenness on the surface of the growing film.

A method for obtaining the structure includes, a method which includes decreasing the temperature of the system at a constant rate, and a method which includes decreasing the temperature of the system while a temperature decreasing rate is stepwise or continuously increased. In the case of a method which includes decreasing the temperature of the system at a constant rate, it is preferred that supersaturation temperature is 5 to 15°C, a temperature decreasing rate is 0.2 to 2°C/minute, and a growth time is 30 to 120 minutes. However, with this method, thickness of a bulk portion may be insufficient in some cases. Therefore, the latter method is preferably applicable. More specifically, the following process is performed. At the initial stage of liquid phase epitaxy (which is the step of forming a bulk portion), a temperature decreasing rate of a solution is set to be small to grow a crystal so that the bulk portion is formed by flat growth. Thereafter, in the step of forming a surface portion, a temperature decreasing rate of the solution is set to be large to grow the crystal so that the surface portion is formed by facet growth. In the step of forming the bulk portion, it is preferred that the supersaturation temperature is 2 to 14°C, a temperature decreasing rate is 0 to 0.2°C/minute, and a growth time is 10 to 60 minutes. In the step of forming the surface portion, it is preferred that a temperature decreasing rate is 0.2 to 2°C/minute, and a growth time is 30 to 120 minutes. It is more preferred that a temperature decreasing rate be increased stepwise in the step of forming the surface portion.

However, growth conditions are generally regulated by a feeding rate of a silicon material (a crystal material) to a substrate. More specifically, growth conditions are appropriately set depending on the kind or a volume of a solution, a material dissolving temperature, the supersaturation temperature, a temperature decreasing rate, and spacing between substrates.

For example, in the system where silicon is dissolved to be saturated in 11 kg of an In solution at 900°C to prepare a solution and a substrate is individually and vertically held in the solution to perform liquid phase epitaxy, if crystal growth is performed with the temperature of the solution for crystal growth being decreased to approximately 885°C to be supersaturated, a temperature decreasing rate after dipping the substrate being 0.2°C/minute, and a growth time being 150 minutes, then a silicon film 2, which includes a bulk portion 2a having a thickness of approximately 20 µm and a surface portion 2b having protrusions of approximately 60 µm in height, is obtained.

As is apparent from Fig. 1, in many cases, plural protrusions in the surface portion 2b have characteristics that the overhangs 3 in a lateral direction have planes of almost the same inclination. The planes having almost the same inclination are formed not only on the surface side but also on the lower side of the respective overhangs 3 (i.e., the plane including a gap portion). It is conceivable that this is due to (111) surface or (100) surface which is predominant at the growth of the surface portion 2b. The gap portion formed on the lower side of the overhang 3 shown in Fig. 1 continuously extends in a direction perpendicular to the drawing sheet. In other words, a groove 5 having a dead end shape is formed on the surface. The width of an opening of the groove may be controlled to be 0.1 to 50 µm and the vertical depth from the opening to the deepest end of the groove may be controlled to be 5 to 100 µm. Furthermore, a void 4, which does not communicate with the outside, may be formed at the inside of the silicon film 2 by connection of the adjacent overhangs.

By controlling the width of the opening of the groove to be in the range of 0.1 to 50 µm, incident light would be introduced into the dead end of the groove so that reflection and absorption would be repeated in the groove. As a result, efficiency for light utilization would be increased. Furthermore, even in the case where a conductive paste is used for a collector electrode, the collector electrode would cross over the groove so as to prevent a cut off of the electrode. As a result, current collecting efficiency would be remarkably improved. Also, by controlling the vertical depth to be in the range of 5 to 100 µm, efficiency for light utilization would be increased as described above. Furthermore, a surface passivation effect due to an oxide film or a nitride film would be remarkably improved.

Furthermore, according to the present invention, a solar cell is manufactured by forming a P-N junction on a silicon film on which there exist "overhangs 3 in a lateral direction the planes of which having almost the same inclination (an inclined plane)" which can be formed by the above-mentioned growth method. Therefore, it is possible to manufacture a solar cell having capability of more effectively introducing incident light into a dead end of a groove compared to a conventional solar cell merely having a dead end structure on the surface thereof. As a result, it is possible to further increase efficiency for light utilization of a solar cell.

In the present invention, inexpensive multicrystalline silicon can be used as the substrate 1. Furthermore, since a solar cell according to the present invention utilizes the silicon film 2 as a photoactive layer, especially inexpensive metallurgical grade multicrystalline silicon can be used as the result. The term "metallurgical grade silicon" means silicon obtained by directly reducing a silica sand. Such silicon usually has purity of less than 99.99%, but it is far inexpensive compared to semiconductor class silicon or solar cell class silicon. In the case of using a metallurgical grade multicrystalline substrate, it is preferred that the substrate is washed with a mixed liquid of sulfuric acid and hydrogen peroxide and subjected to a so-called planar etching (a flattening treatment) using mixed acid of hydrofluoric acid, nitric acid, and acetic acid prior to an epitaxial growth of a silicon film.

A liquid phase epitaxy is used for obtaining a silicon film having an uneven structure on the surface thereof according to the present invention. Fig. 2 is a schematic cross-sectional view illustrating an example of a liquid phase epitaxial growth apparatus for forming the silicon film.

A growth furnace 21 includes a crucible 22 therein and is surrounded by a heater 23. The crucible 22 contains a melt (a solution for crystal growth) 24 in which a silicon material is dissolved to be saturated in metal such as tin, indium, copper, or aluminum. A substrate loading chamber 26 is coupled to the upper portion of the growth furnace 21 through a gate valve 25. The substrate loading chamber 26 is horizontally slidable and includes a substrate holder 27 therein.

A growth process is performed as follows. When the gate valve 25 is closed, the growth furnace 21 is kept at the saturation temperature of the melt under hydrogen atmosphere. A substrate 28 is held on the substrate holder 27 while the substrate loading chamber 26 is separated from the growth furnace 21. Then the substrate loading chamber 26 is coupled to the growth furnace 21 and the inside thereof is replaced with hydrogen. Thereafter, the gate valve 25 is opened so that the substrate holder 27 lowered to be brought into the growth furnace 21 to heat the substrate 28 for a predetermined time under hydrogen atmosphere. Then, the temperature of the growth furnace 21 is decreased to the extent that the silicon material in the melt 24 is supersaturated. When the temperature of the furnace reaches the temperature at which a predetermined degree of supersaturation is attained, the substrate holder 27 is further lowered so that the substrate 28 is dipped in the melt 24. If the temperature of the growth furnace 21 is decreased at a predetermined temperature decreasing rate under the above-mentioned condition, then a silicon film is epitaxially grown on the substrate 28. When a desired silicon film is obtained, the substrate holder 27 is raised and the gate valve 25 is closed. Next, the inside of the substrate loading chamber 26 is replaced with air and the substrate loading chamber 26 is separated from the growth furnace 21 to take out the substrate 28. The melt 24 may contain a dopant such as gallium, phosphorous, boron or aluminum.

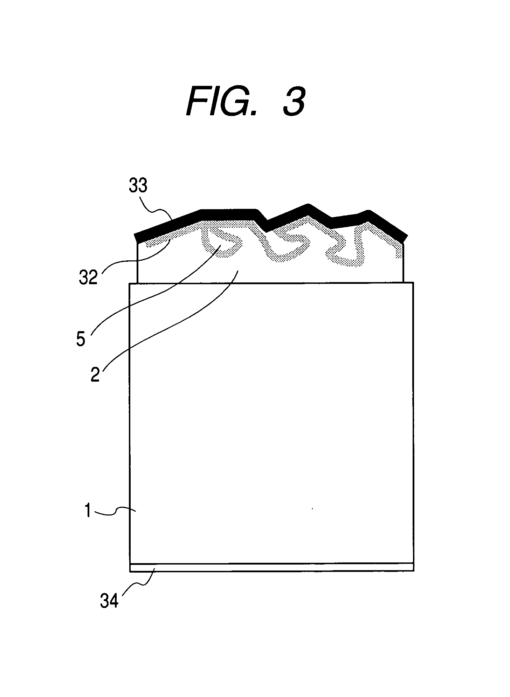

Fig. 3 is a schematic cross-sectional view illustrating an embodiment of a solar cell according to the present invention. A P-type silicon film 2 is formed on a substrate 1 by the above-mentioned method. An n+ layer (not shown), an antireflection film 32, and a collector electrode 33 are formed on the surface of the silicon film 2. A back electrode 34 is formed on the back side of the substrate 1. The n+ layer can be formed by thermal diffusion, ion implantation or the like. The antireflection film 32 can be formed by sputtering, deposition, CVD, or the like using an oxide film or a nitride film. The collector electrode 33 and the back electrode 34 can be formed by sputtering, vapor deposition, printing, or the like using silver or aluminum. A solar cell according to another embodiment may include a hetero junction with an amorphous film on a multicrystalline silicon substrate. For example, a configuration in which an amorphous i layer and an amorphous n layer are laminated on a P-type silicon film 2 may be employed. An amorphous layer can be formed by, for example, a CVD method.

The silicon film of the present invention includes plural protrusions that overhang in a lateral direction on the surface thereof. Many of the adjacent overhangs are separated from each other by a groove 5 having a dead end shape. Therefore, according to a solar cell of the present invention, it is possible to improve current collecting efficiency by forming a collector electrode 33 crossing over the groove 5 as shown in Fig. 3. At the portion where the collector electrode crosses over the groove 5, the collector electrode is arranged in midair. Applicable examples of a method of forming a collector electrode having such a structure include a method which includes applying a conductive paste having a relatively high viscosity onto a substrate and baking it, a method which further includes laminating metal having a low melting point such as solder on the baked paste, and a method which includes sticking a metal wire on the substrate with a conductive adhesive.

### (Example)

### (Pre-treatment of substrate)

A metallurgical grade multicrystalline silicon substrate having 47 mm length, 47 mm width and 0.6 mm thickness was used as a substrate. The substrate was washed with flowing water for 5 minutes and then dipped in a mixed liquid of sulfuric acid and hydrogen peroxide (mixed ratio of 3 to 1) for 10 minutes. The substrate was additionally washed with flowing water for 5 minutes and then dipped in a mixed liquid of nitric acid, acetic acid, and hydrofluoric acid (mixed ratio of 600/136/64) for 6 minutes and 30 seconds to perform a planar etching on the surface thereof. Finally, the substrate was washed with flowing water for 5 minutes and then dried by blowing dry nitrogen thereto, so as to complete a pre-treatment of the substrate.

### (Manufacturing of solar cell)

A silicon film was epitaxially grown on the above-mentioned metallurgical grade multicrystalline silicon substrate using a liquid phase growth apparatus as shown in Fig. 2. A melt 24 was prepared by dissolving and saturating a silicon material in 11 kg of indium at 900°C. The temperature of the melt was decreased to 886°C so as to produce a supersaturation condition. Then, the substrate 28 was dipped in the supersaturated melt. The substrate 28 was rotated at 10 rpm in the melt. The melt 24 was gradually cooled at a temperature decreasing rate of 0.1°C/minute for the initial 10 minutes, 0.5°C/minute for the next 10 minutes and 1.0°C/minute for the remaining 40 minutes. As a result, a silicon film having a thickness of 40 to 60 µm was obtained in the 60 minutes. The silicon film included a bulk portion (20 µm thickness) and a surface portion (20 to 40 µm thickness) having plural protrusions that overhang in a lateral direction.

Next, a process of manufacturing a solar cell will be described with referring to Fig. 3. A P-type silicon film 2 was formed by a liquid deposition method on a multicrystalline silicon substrate 1 according to the present invention, as described above. An N-type diffusion source was applied onto the surface of the silicon film 2 with a thickness of 2,000 angstroms and baked at 860°C to form an n+ layer (not shown). Then, ITO was sputtered with a thickness of 820 angstroms to form an antireflection film 32. Next, a silver paste was applied in a grid shape by a screen printing and then baked to form a collector electrode 33. In addition, a silver paste was applied onto the back side of the substrate 1 and baked to form a back electrode 34. As a result, a solar cell was obtained.

As described above, according to a method for growing a silicon film of the present invention, it is possible to form a silicon film having an uneven structure suitable for increasing optical path length on the surface of a semiconductor substrate without performing an additional process for forming an uneven structure. Therefore, it is possible to especially obtain a semiconductor substrate suitable for a solar cell having an improved short circuit current property at a low cost. As a result, it is possible to provide a solar cell having high efficiency and being low in price.

According to the present invention, at the time of growing a silicon film by liquid epitaxy on a substrate, a bulk portion having substantially no void is formed and then a surface portion having plural protrusions that overhang in a lateral direction is formed. As a result, it is possible to form a silicon film having an uneven structure suitable for increasing optical path length on a surface layer of a semiconductor substrate without performing an additional process for forming an uneven structure. Therefore, it is possible to obtain a semiconductor substrate particularly suitable for a solar cell having an improved short circuit current property at low cost. Accordingly, it is possible to provide a solar cell having high efficiency and being low in price.

## Claims

1. A method for growing a silicon film by liquid phase epitaxy on a surface of a substrate in contact with a solution containing at least silicon by decreasing a temperature of the solution, comprising the steps of:
forming a bulk portion having substantially no void; and
forming a surface portion having plural protrusions that overhang in a lateral direction.

2. The method for growing a silicon film according to claim 1, wherein a temperature decreasing rate of the solution in the step of forming the surface portion is larger than a temperature decreasing rate of the solution in the step of forming the bulk portion.

3. The method for growing a silicon film according to claim 1, wherein the plural protrusions that overhang in the lateral direction have at least one of surfaces and insides which have planes of almost the same inclination.

4. The method for growing a silicon film according to claim 1, wherein a multicrystalline silicon substrate is used as the substrate.

5. The method for growing a silicon film according to claim 1, wherein the surface portion of the silicon film has a void which does not communicate with the outside.

6. A method for manufacturing a solar cell comprising the method for growing a silicon film according to claim 1, further comprising the step of:
forming a P-N junction on the silicon film obtained by the growing method.

7. A semiconductor substrate comprising an inclined plane and plural grooves of a gap portion communicated with the inclined plane in a surface layer composed of silicon.

8. A semiconductor substrate comprising a surface portion having an inclined plane affected by a crystal structure of silicon and plural protrusions that overhang in a lateral direction in a surface layer composed of silicon,
wherein plural grooves having openings narrowed due to the protrusions overhanging in the lateral direction are formed in the surface portion.

9. The semiconductor substrate according to claim 8, wherein the inclined plane is (111) surface or (100) surface of a silicon crystal.

10. The semiconductor substrate according to claim 8, wherein a width of the opening of each groove is 0.1 to 50 µm.

11. The semiconductor substrate according to claim 8, wherein a vertical depth from the opening of each groove to a deepest end of each groove is 5 to 100 µm.

12. A solar cell comprising the semiconductor substrate according to claim 8 as a component,
wherein a P-N junction is formed on the surface layer composed of silicon.

13. A solar cell comprising a collector electrode crossing over the plural grooves on the semiconductor substrate according to claim 8.
